# EUROPÄISCHE PATENTSCHRIFT

(11) **EP 2 071 645 B1**
(45) Veröffentlichungstag und Bekanntmachung des Hinweises auf die Patenterteilung: **23.12.2015**
(21) Anmeldenummer: 08105687.1
(22) Anmeldetag: 29.10.2008
(51) Int. Cl.: H01L 41/083

(54) **Piezoaktor mit einem Multilagenaufbau von Piezoelementen**
Piezo actuator module with a multiple structure of Piezo elements
Module piézoactionneur doté d'une construction multicouches de piézoactionneurs

(30) Priorität: 13.12.2007 DE 102007060167
(43) Veröffentlichungstag der Anmeldung: 17.06.2009
(73) Patentinhaber: ROBERT BOSCH GMBH, 70442 Stuttgart (DE)
(72) Erfinder: Benes, Jan, 96047 Bamberg (DE); Pohl, Gerd, 02906 Waldhufen Thiemendorf (DE)

(56) Entgegenhaltungen:
- DE-A1-102004 031 402
- US-A1- 2005 168 106
- US-A1- 2006 043 841
- US-A1- 2006 238 073
- US-A1- 2007 084 034

## Beschreibung

### Stand der Technik

Die Erfindung betrifft einen Piezoaktor mit einem Multilagenaufbau von Piezoelementen, beispielsweise zur Betätigung eines mechanischen Bauteils wie ein Ventil oder dergleichen, nach dem Oberbegriff des Anspruchs 1.

Es ist an sich bekannt, dass zum Aufbau des zuvor erwähnten Piezoaktors die Piezoelemente so eingesetzt werden können, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors aus der DE 199 28 177 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement als Stapel mehrerer elektrisch miteinander gekoppelter piezokeramischer Schichten aufgebaut, der unter Vorspannung zwischen zwei Anschlägen gehalten ist. Jede piezokeramische Schicht ist als Piezolage zwischen zwei Innenelektroden eingefasst, über die von außen eine elektrische Spannung angelegt werden kann. Aufgrund dieser elektrischen Spannung führen die piezokeramischen Schichten dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potenziale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind. Bei einer Betätigung des Piezoaktors treten unterschiedliche mechanische Kräfte im Bereich der Innenelektroden sowie im Bereich der Kontaktierungen an den Außenelektroden auf, die zu mechanischen Spannungen und dadurch zu Rissen in den Außenelektroden oder im Piezoaktor führen können. Die Außenelektroden müssen dann wiederum mit Anschlusselektroden versehen werden, die weiter nach außen geführt werden und in der Regel auch mechanischen Spannungen standhalten müssen. Bei dem eingangs erwähnten Stand der Technik DE 199 28 177 A1 wird zur Vermeidung von solchen Nachteilen einer Rissbildung mittels einer besonderen Formgebung des gesamten Multilagenaufbaus im Randbereich eine mechanische Vorspannung an die gefährdeten Stellen gebracht.

Diese durch Zugspannungen insbesondere im Bereich der Isolationszonen auftretenden Rissbildungen, auch Polungsrisse genannt, limitieren die Robustheit des Multilagenaufbaus und können bei einem Rissverlauf im elektrischen Feld zwischen den Innenelektroden zu starken Schädigungen führen, da hier elektrische Leitpfade durch eingetragene Stoffe oder chemische bzw. elektrochemische Angriffe, usw. entstehen können.

Weitere Beispiele sind in den Patentschriften US2006/043841 und DE10 2004 031402 bekannt.

### J Offenbarung der Erfindung

Die Erfindung geht von einem eingangs beschriebenen Piezoaktor aus, der mit einem Mehrlagenaufbau von Piezoelementen und zwischen den Piezolagen der Piezoelemente angeordneten Innenelektroden versehen ist. Die Innenelektroden sind in Richtung des Lagenaufbaus des Piezoelements abwechselnd mit einer unterschiedlichen Polarität einer elektrischen Spannung über eine wechselseitige seitliche Kontaktierung beaufschlagt. Zur Vermeidung des negativen Einflusses von Rissbildung im Lagenaufbau ist gemäß der Erfindung in vorteilhafter Weise an vorgegebenen Stellen des Lagenaufbaus zwischen den Piezoelementen mindestens eine planare Trennlage mit mindestens an der Kontaktierung der Innenelektroden angeordneten Beschichtungen in vorgegebenen Bereichen angeordnet.

Die Beschichtung besteht dabei bevorzugt aus organischem oder metallischem Material, das durch eine Sinterung des Piezoaktors weitgehend zerstörbar ist. Die Bereiche der Beschichtungen überdecken dabei in etwa die Fläche von der Außenfläche des Piezoaktors bis zur an dieser Außenfläche des Piezoaktors nicht kontaktierten Innenelektrode, also den Bereich der Isolationszone. Erfindungsgemäss weisen die an die jeweilige Trennlage angrenzenden Innenelektroden dabei jeweils die gleiche Polarität der anliegenden elektrischen Spannung auf.

Bei einem vorteilhaften Verfahren zur Herstellung eines zuvor beschriebenen Piezoaktors wird die jeweilige Trennlage durch Bedrucken eines jeweils angrenzenden Piezoelements mit dem zuvor beschriebenen Material in dem Bereich der Beschichtung hergestellt, wobei das Material während der Sinterung des Piezoaktors weitgehend reduziert wird.

Mit der erfinderischen Lösung wird an mindestens einer Stelle zwischen den alternierend gestapelten positiven und negativen Innenelektroden des Lagenaufbaus der Piezolagen aus Keramik durch eine planar eingebrachte Trennlage ein definierter Abbau von mechanischen Spannungen erreicht und im Sonderfall kann eine definierte Rissbildung erfolgen, die nicht so nachteilig ist, wie beim Stand der Technik. Dabei ist die Aufbautechnik und das Design der Innenelektroden weitgehend unmaßgeblich.

Im Bereich der Trennlage entfällt eine negative oder positive Lage, sodass die Trennlage in vorteilhafter Weise zwischen zwei gleichpoligen Lagen aufgebaut ist und somit kein elektrisches Feld zwischen diesen Lagen bzw. den jeweiligen Innenelektroden anliegt.

Der Vorteil der Erfindung liegt insbesondere in der einfachen Herstellung der Trennlagen bei einer Erhöhung der Robustheit der so gebildeten Piezoaktoren.

Unter Verzicht auf eine positive oder negative Innenelektrode und stattdessen dem Einbau einer Trennlage als Sollbruchstelle wird somit eine definierte Spannungsverminderung bzw. ein Spannungsabbau ermöglicht. Die Trennlage wird je nach dem gewählten Verfahren oder Material ganz bis teilweise entfernt. Dies erfolgt während der Entbinder- und/oder Sinterphase, sodass die Sinterung in diesem Bereich ganz oder teilweise behindert ist; der Trenneffekt wandelt sich somit in den erwähnten Sollbrucheffekt.

Vorzugsweise erfolgt dies, wie zuvor beschrieben, durch Drucken einer vorzugsweise organischen oder metallischen Beschichtung, die im Zuge der Sinterung des Piezoaktors zerstört oder entfernt sodass keine oder zumindest keine starke verringerte Bindung der benachbarten Keramikschichten der Piezoelemente in diesem Bereich auftritt.

Dabei muss die Fläche, das Design und die Schichtdicke der Trennlage an die jeweilige Materialpaarung der Piezoelemente und dem jeweiligen Entfernungsverfahren angepasst werden. Die Zahl der eingebauten Trennlagen kann dabei von mindestens einer bis zu der technisch relevanten Anzahl an bekannten möglichen Hauptpolungsrissen reichen. Ihre Anzahl ist nur durch den tolerierbaren Verlust an Hub des Piezoaktors oder durch eine mögliche dementsprechende Verlängerung des Piezoaktors eingeschränkt. Die Form der Trennlage ist im Allgemeinen, wie beschrieben, der Isolationszone angepasst, jedoch können auch hiervon abweichende Gestaltungen je nach Geometrie de Piezoaktors den gewünschten Effekt herbeiführen.

### Kurze Beschreibung der Zeichnungen

Ausführungsbeispiele des erfindungsgemäßen Piezoaktors werden anhand der Zeichnung erläutert. Es zeigen:
- Figur 1: einen Schnitt durch einen Piezoaktor mit einem Mehrlagenaufbau von Piezolagen und Innenelektroden als Piezoelemente,
- Figur 2: eine Detailansicht eines Ausschnitts einer erfindungsgemäßen Trennlage zischen Piezoelementen mit planaren Trennlagen in einer Draufsicht auf die Trennlage,
- Figur 3: eine Ansicht der Trennlage nach der Figur 2 im Schnitt,
- Figur 4: einen Detailschnitt entsprechend der Figur 1 mit einem Längsriss in der Trennlage und
- Figur 5: einen Detailschnitt entsprechend der Figur 1 mit Querrissen in der Trennlage.

### Ausführungsformen der Erfindung

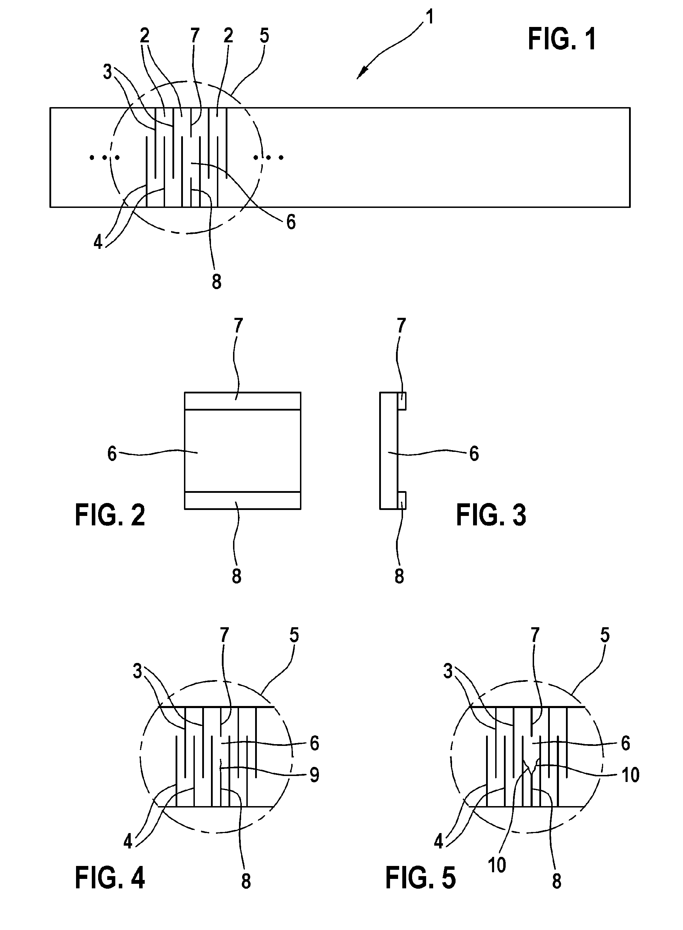

In Figur 1 ist ein beispielsweise im Prinzip aus dem eingangs erwähnten Stand der Technik DE 199 28 177 A1 bekannter Piezoaktor 1 gezeigt, der Piezoelemente 2 aus Piezolagen oder -folien aufweist, die unter Ausnutzung des Piezoeffekts bei Anlage einer elektrischen Spannung an Innenelektroden 3 und 4 eine mechanische Reaktion des Piezoaktors 1 in Richtung des Lagenaufbaus bewirken. Die elektrische Spannung wir über hier nicht dargestellte Außenelektroden beispielsweise mit positivem Potenzial an die hier oben liegende Seite mit den an den Rand herausgeführten Innenelektroden 3 und mit dem negativen Potenzial an die hier unten liegende Seite mit den an den Rand herausgeführten Innenelektroden 4 an den Piezoaktor herangeführt, so dass die Innenelektroden 3 und 4 somit in Richtung des Lagenaufbaus der Piezoelemente 2 abwechselnd mit einer unterschiedlichen Polarität einer elektrischen Spannung beaufschlagt werden.

Das Ausführungsbeispiel wird hier nur anhand eines Ausschnitts 5 erläutert, der zusätzlich zu dem herkömmlichen bekannten Aufbau noch eine Trennlage 6 enthält, die nicht als Innenelektrode wirkt und lediglich in einem vorgegebenen Bereich 7 und 8 an den kontaktierten Seiten des Piezoaktors 1 im Lagenaufbau liegt.

Der Piezoaktor 1 kann dann über einen hier nicht dargestellten Aktorkopf und einen Aktorfuß an den jeweiligen Enden des Lagenaufbaus fest in ein Gehäuse, beispielsweise das Gehäuse eines Einspritzventils für Kraftfahrzeuge zur Steuerung des Ventils, eingebettet werden und damit Bestandteil eines sogenannten Piezoinjektors sein.

In Figur 2 ist die Trennlage 6 gemäß des Schnitts nach der Figur 1 in einer Draufsicht gezeigt, wobei hier die beiden Bereiche 7 und 8 deutlich erkennbar sind. Figur 3 zeigt die Trennlage 6 mit den Bereichen 7 und 8 nochmal in einem Schnitt in einer vergrößerten Ansicht.

Aus Figur 4 ist der Ausschnitt 5 nach der Figur 1 zur Erläuterung der Erfindung mit einem mechanischen längs verlaufenden Riss 9 am Bereich 8 in die Trennlage 6 gezeigt, der durch die in der Beschreibungseinleitung erwähnten physikalischen Randbedingung auftreten kann.

In Figur 5 ist der Ausschnitt 5 nach der Figur 1 zur Erläuterung der Erfindung mit zwei quer von dem Bereich 8 der Trennlage 6 quer zu den Innenelektroden 4 verlaufenden Rissen 10 gezeigt, die ebenfalls durch die in der Beschreibungseinleitung erwähnten physikalischen Randbedingung auftreten können. Ein solcher im Extremfall quer oder schräg verlaufener Riss 10, der in Richtung beider benachbarter Innenelektroden 4 verläuft, ist dadurch entschärft, dass beide angrenzenden Innenelektroden 4 gleiches Potenzial haben und ein derartig verlaufener Riss 10 ohne ein elektrisches Feld zu keinem elektrischen Überschlag führen kann.

## Patentansprüche

1. Piezoaktor, mit einem Mehrlagenaufbau von Piezoelementen (2) mit Piezolagen zwischen Innenelektroden (3,4), die in Richtung des Lagenaufbaus des Piezoaktors (1) abwechselnd mit einer unterschiedlichen Polarität einer elektrischen Spannung beaufschlagt sind, wobei an vorgegebenen Stellen des Lagenaufbaus zwischen den Piezoelementen (2) mindestens eine nicht als Innenelektrode wirkende planare Trennlage (6) mit mindestens an der Kontaktierung der Innenelektroden (3,4) angeordneten Beschichtungen in vorgegebenen Bereichen (7,8) angeordnet ist, wobei die Beschichtungen aus metallischem Material bestehen, das durch eine Sinterung des Piezoaktors (1) zerstörbar ist, wobei die an die jeweilige Trennlage (6) angrenzenden Innenelektroden (3,4) jeweils die gleiche Polarität der anliegenden elektrischen Spannung aufweisen.

2. Piezoaktor nach Anspruch 1, **dadurch gekennzeichnet, dass** die Bereiche (7,8) der Beschichtungen in etwa die Fläche von der Außenfläche des Piezoaktors (1) bis zur an dieser Außenfläche des Piezoaktors (1) nicht kontaktierten Innenelektrode (3,4) überdecken.

3. Piezoaktor nach einem der vorhergehenden Ansprüche, **dadurch gekennzeichnet, dass** der Piezoaktor (1) Bestandteil eines Piezoinjektors zur Steuerung der Kraftstoffeinspritzung bei einem Verbrennungsmotor ist.

## Claims

1. Piezo actuator having a multi-layer structure of piezo elements (2) with piezo layers between internal electrodes (3, 4) to which an electric voltage is alternately applied with a different polarity in the direction of the layered structure of the piezo actuator (1), wherein at least one planar separating layer (6), which does not act as an internal electrode, with coatings arranged at least on the contact surface of the internal electrodes (3, 4), is arranged in predefined areas (7, 8) at predefined locations on the layered structure between the piezo elements (2), wherein the coatings are composed of metallic material which can be destroyed by sintering of the piezo actuator (1), wherein the internal electrodes (3, 4) which adjoin the respective separating layer (6) each have the same polarity of the applied electrical voltage.

2. Piezo actuator according to Claim 1, **characterized in that** the regions (7, 8) of the coatings cover the surface of the external face of the piezo actuator (1) approximately as far as the internal electrode (3, 4) which is not in contact with this external face of the piezo actuator (1).

3. Piezo actuator according to one of the preceding claims, **characterized in that** the piezo actuator (1) is a component of a piezo injector for controlling the injection of fuel in an internal combustion engine.

## Revendications

1. Actionneur piézoélectrique comprenant une structure multicouche d'éléments piézoélectriques (2) avec des couches piézoélectriques entre des électrodes internes (3, 4) qui sont sollicitées dans la direction de la structure en couches de l'actionneur piézoélectrique (1) en alternance avec une polarité différente d'une tension électrique, au moins une couche de séparation plane (6), n'agissant pas en tant qu'électrode interne, étant disposée à des emplacements prédéfinis de la structure en couches entre les éléments piézoélectriques (2) avec au moins des revêtements disposés dans des régions prédéfinies (7, 8) au niveau du contact des électrodes internes (3, 4), les revêtements étant constitués de matériau métallique qui peut être détruit par frittage de l'actionneur piézoélectrique (1), les électrodes internes (3, 4) adjacentes à la couche de séparation respective (6) présentant à chaque fois la même polarité que la tension électrique appliquée.

2. Actionneur piézoélectrique selon la revendication 1, **caractérisé en ce que** les régions (7, 8) des revêtements recouvrent approximativement la surface de la surface extérieure de l'actionneur piézoélectrique (1) jusqu'à, l'électrode interne (3, 4) non mise en contact au niveau de cette surface extérieure de l'actionneur piézoélectrique (1).

3. Actionneur piézoélectrique selon l'une quelconque des revendications précédentes, **caractérisé en ce que** l'actionneur piézoélectrique (1) fait partie d'un injecteur piézoélectrique pour la commande de l'injection de carburant dans un moteur à combustion interne.
